# FASCICULE DE BREVET EUROPEEN

(11) **EP 2 537 171 B1**
(45) Date de publication et mention de la délivrance du brevet: **24.12.2014**
(21) Numéro de dépôt: 11708921.9
(22) Date de dépôt: 11.02.2011
(51) Int. Cl.: H01H 9/16, F02K 1/76, H01H 47/00, G01R 31/00

(54) **CIRCUIT DE DETECTION DES POSITIONS DE CONTACTEURS DANS UNE TURBOMACHINE**
SCHALTUNG ZUR DETEKTION DER SCHALTZUSTÄNDE VON SCHÜTZE IN EINER STRAHLTURBINE
CIRCUIT FOR THE DETECTION OF THE POSITIONS OF CONTACTORS IN A TURBOJET

(30) Priorité: 18.02.2010 FR 1000684
(43) Date de publication de la demande: 26.12.2012
(73) Titulaire: Snecma, 75015 Paris (FR)
(72) Inventeur: STORN, Maxime, F-77550 Moissy Cramayel Cedex (FR)
(74) Mandataire: Ramey, Daniel
(86) Numéro de dépôt international: PCT/FR2011/050289
(87) Numéro de publication internationale: WO 2011/101581

(56) Documents cités:
- EP-A1- 0 638 913
- DE-A1- 10 347 979
- US-A1- 2003 025 515

## Description

La présente invention concerne un circuit de détection des positions individuelles de contacteurs électriques ainsi que son application à des portes d'inverseurs de poussée dans une turbomachine.

Les turbomachines actuelles comprennent de nombreux calculateurs recevant chacun des informations en provenance de capteurs tels que des contacteurs et interprétant ces informations pour déterminer des actions à entreprendre.

Ceci est par exemple le cas des dispositifs d'inversion de poussée couramment utilisés pour ralentir l'avion et assister le système de freinage pour réduire la distance nécessaire à l'immobilisation de l'avion.

De manière connue, un dispositif d'inversion de poussée comprend une pluralité de portes escamotables qui sont déployées lors du freinage et fermées lors des autres phases de vol. Chaque porte peut être équipée d'au moins trois contacteurs à deux états, ouvert ou fermé, un contacteur étant destiné à renvoyer une information sur la position ouverte de la porte, un autre à renvoyer une information sur la position fermée de la porte et le dernier sur le verrouillage de la porte. De plus, pour des raisons de sécurité, il est nécessaire de doubler chaque contacteur pour maintenir la fiabilité de l'information transmise au calculateur.

Ainsi, on comprend que plus on augmente le nombre de contacteurs plus on augmente le nombre d'entrées et sorties à interfacer avec le calculateur, ce qui implique un encombrement plus important pour le calculateur et un nombre important de fils de connexion entre le calculateur et les contacteurs positionnés au niveau des portes des inverseurs de poussée.

Pour remédier à cette difficulté, la déposante a déjà proposé dans sa demande EP0638913A1 de réaliser un circuit comportant des contacteurs à deux positions de contact agencés en parallèle et associés à des résistances, afin de réduire le nombre d'entrées et de sorties.

Le document US 2003/025515 A1 concerne un circuit de détection des positions individuelles d'une pluralité de contacteurs électriques à deux positions et reliés en série, à des résistances permettant de savoir si un connecteur est défaillant ou non.

Toutefois, les solutions proposées présentent plusieurs inconvénients. En effet, dans un premier cas, une défaillance d'un contacteur peut entraîner une mauvaise lecture de la position des autres contacteurs. Dans un deuxième cas, il est possible de connaître le nombre de contacteurs ouverts ou fermés sans pouvoir préciser leur position individuelle.

L'invention a notamment pour but d'apporter une solution simple, efficace et économique à au moins une partie de ces problèmes.

A cette fin, elle propose un circuit de détection des positions individuelles d'une pluralité de contacteurs électriques caractérisé en ce qu'il comprend :
- une pluralité de modules reliés en parallèle ou en série et comportant chacun un contacteur à k positions distinctes de contact chacune reliée en série à une résistance associée à une valeur entière d'état comprise entre 1 et k, les valeurs d'état dans un même module étant distinctes deux à deux;
- chaque module étant associé à un coefficient de pondération et ces coefficients de pondération suivant une progression géométrique de raison supérieure ou égale à k+1 ; et en ce que
- la valeur de la conductance électrique (ou de la résistance ohmique, respectivement) de chaque résistance est égale à sa valeur d'état multipliée par le coefficient de pondération de son module.

L'interfaçage du circuit selon l'invention avec un calculateur ne nécessite qu'un nombre réduit de fils puisque l'information sur la position individuelle de contact d'un contacteur est obtenue par mesure de la conductance totale du circuit lorsque les modules sont en parallèle et par la mesure de la résistance ohmique totale lorsque les modules sont montés en série. Ainsi, le nombre de fils reliant le circuit à un calculateur est indépendant du nombre de contacteurs branchés en parallèle ou en série dans le circuit.

Selon l'invention, la détermination des valeurs de conductances (ou de résistances, respectivement) par multiplication de la valeur d'état et du coefficient de pondération du module rend unique la valeur de conductance totale (ou de résistance ohmique totale, respectivement) du circuit pour une position de contact donnée de chacun des contacteurs. En effet, la valeur de la conductance totale (ou résistance ohmique totale, respectivement) obtenue correspond à une décomposition de cette valeur dans une base de valeur au moins égale à k+1, ce qui la rend unique.

L'unicité de la valeur de conductance (ou de résistance ohmique, respectivement) permet ainsi par simple mesure de la conductance (ou de la résistance ohmique, respectivement) du circuit de déterminer les positions individuelles de contact de chacun des contacteurs.

Lorsque les modules sont branchés en parallèle et en cas de défaillance d'au moins un contacteur, ce dernier se trouve en position ouverte. Cette position ouverte revient à attribuer au contacteur un état 0 dans lequel il ne participe pas à la conductance totale du circuit. La mesure de la conductance totale du circuit indique une valeur de conductance totale différente de celle obtenue si le contacteur est dans une position de contact (c'est-à-dire relié à une résistance).

Ainsi, le branchement en parallèle des modules présente l'avantage par rapport à un branchement en série de permettre la détection de la défaillance d'un ou de plusieurs des contacteurs et également de connaître précisément lequel ou lesquels de ce ou ces contacteurs est ou sont défaillants. La fiabilité du circuit de détection est grandement améliorée et les opérations de maintenance sont simplifiées puisqu'il est possible d'identifier dans le circuit la localisation d'un contacteur défaillant. De plus, la défaillance d'un ou de plusieurs contacteurs n'empêche pas la détermination des positions individuelles de contact des contacteurs en état de fonctionnement normal.

L'invention permet ainsi de réduire le nombre d'entrées nécessaires sur un calculateur tout en obtenant la même quantité d'informations. La réduction du nombre de fils permet de réduire la masse des harnais correspondants, ce qui conduit à une réduction des coûts.

De plus, la conception du circuit sous forme de modules permet l'ajout ultérieur de contacteurs supplémentaires sans avoir d'importantes modifications du circuit puisque le nombre de fils en direction du calculateur est inchangé.

Avantageusement, les modules sont reliés en parallèle et l'ensemble des modules est relié en série à une résistance supplémentaire pour former un pont diviseur de tension, ce qui permet de réduire l'influence des écarts des températures vues par chacune des résistances.

Dans cette configuration, une tension d'alimentation est appliquée à l'ensemble du circuit et l'on mesure la tension aux bornes d'un des modules.

L'invention concerne également un dispositif de détection des positions individuelles des portes d'un inverseur de poussée d'un turboréacteur, comprenant un circuit tel que décrit précédemment, dans lequel la position d'un contacteur est associée à la position d'une porte d'un inverseur de poussée.

Dans ce cas, k peut être égal à 2 et chaque position de contact d'un contacteur est choisie pour donner une information sur le niveau d'ouverture ou de fermeture d'une porte de l'inverseur de poussée.

Dans une réalisation particulière de l'invention, le dispositif comprend au moins trois contacteurs par porte dont deux contacteurs sont utilisés pour la détermination du niveau de fermeture de la porte et un autre contacteur est utilisé pour la détermination du niveau d'ouverture de la porte.

Selon une autre caractéristique de l'invention, les résistances des modules sont montées dans un boîtier éloigné des contacteurs des inverseurs de poussée et relié à un calculateur, ce qui permet de conserver un schéma de câblage identique à celui de l'art antérieur entre ce boîtier et les contacteurs agencés au niveau des inverseurs de poussée. De plus, les résistances sont soumises à une même température puisqu'elles sont montées dans un même boîtier.

L'invention concerne encore une turbomachine, telle qu'un turboréacteur ou un turbopropulseur d'avion, caractérisée en ce qu'elle comprend un circuit de détection ou un dispositif tel que décrit ci-dessus.

L'invention sera mieux comprise et d'autres détails, avantages et caractéristiques de l'invention apparaîtront à la lecture de la description suivante faite à titre d'exemple non limitatif en référence aux dessins annexés dans lesquels :
- la figure 1 représente un circuit de détection selon l'invention dans lequel les modules sont montés en parallèle ;
- la figure 2 représente une variante du circuit de la figure 1 ;
- la figure 3 représente l'intégration dans un boîtier des résistances d'un circuit selon l'invention ;
- la figure 4 représente un circuit selon l'invention dans lequel les modules sont montés en série.

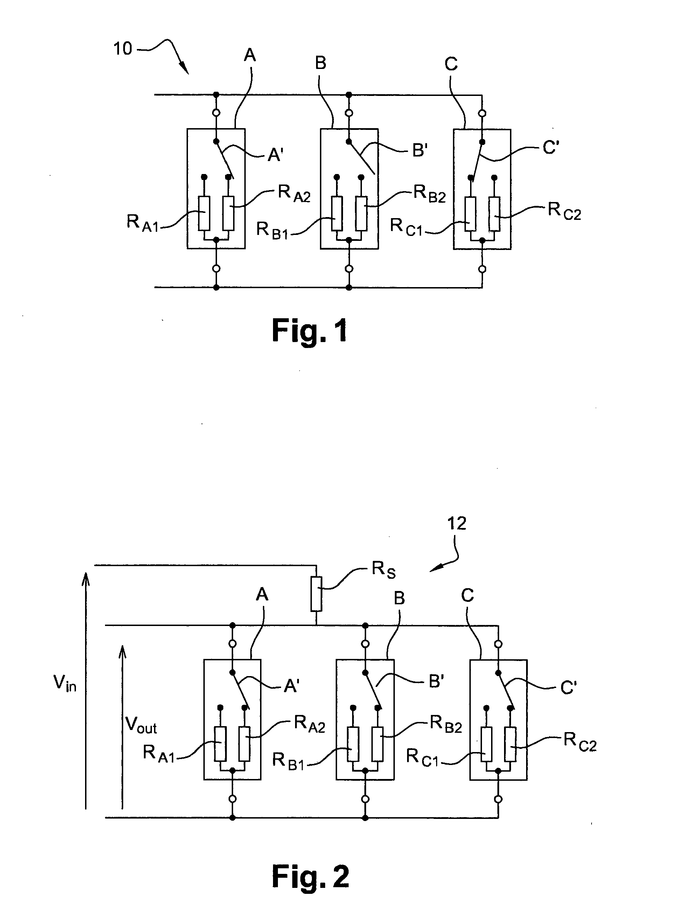

On se réfère tout d'abord à la figure 1 qui représente un circuit de détection 10 selon l'invention comprenant trois modules A, B, C montés en parallèle et comprenant chacun un contacteur A', B', C' capable d'établir deux positions de contact chacune reliée en série à une résistance. Ainsi, le contacteur A' du module A est relié à deux résistances R_{A1}, R_{A2} (l'indice indique le module et le numéro de la résistance), le module B est relié à deux résistances R_{B1}, R_{B2}, et le module C est relié à deux résistances R_{C1}, R_{C2}. Dans chaque module, chaque résistance est associée à une valeur entière d'état, distincte des valeurs d'état des autres résistances du module. Ces valeurs d'état sont positives et comprises entre 1 et le nombre de résistances du module. Dans le cas de la figure 1, les résistances R_{A1}, R_{B1}, R_{C1} sont associées à l'état 1 et les résistances R_{A2}, R_{B2}, R_{C2} sont associées à l'état 2.

Chaque module est associé à un coefficient de pondération, ces coefficients de pondération suivant une progression géométrique de raison 3. Ainsi, le module A est associé au coefficient de pondération 3⁰, le module B est associé au coefficient de pondération 3¹ et le module C est associé au coefficient de pondération 3².

La conductance électrique d'une résistance est calculée en multipliant sa valeur d'état par le coefficient de pondération de son module.

Le tableau ci-dessous résume les différents états possibles de chacun des contacteurs des trois modules ainsi que leurs valeurs de conductance électrique en fonction du coefficient de pondération appliqué au module.

| | Module A | | | Module B | | | Module C | | |
|---|---|---|---|---|---|---|---|---|---|
| | | R_{A1} | R_{A2} | | R_{B1} | R_{B2} | | R_{C1} | R_{C2} |
| Etat | 0 | 1 | 2 | 0 | 1 | 2 | 0 | 1 | 2 |
| Coefficient de pondération | 3⁰ | | | 3¹ | | | 3² | | |
| Conductance électrique (S) | 0 | 1 | 2 | 0 | 3 | 6 | 0 | 9 | 18 |

Notons que ce tableau comprend également le cas où l'état d'un contacteur est nul correspondant à un circuit ouvert, ce qui est le cas lorsque le contacteur est en panne. Dans ce cas, la conductance d'un tel module est nulle.

Dans le cas du circuit de la figure 1, on relève que le contacteur du module A est dans l'état 2, le contacteur du module B est dans l'état 0 correspondant à la position ouverte et le contacteur du module C est en position 1. Il ressort que la conductance totale du circuit est égale à 2+0+9 c'est-à-dire à 11.

Cette valeur de conductance est unique et correspond uniquement à la combinaison de l'état 2 pour le contacteur 1 du module A, de l'état 0 pour le module B et de l'état 1 pour le module C.

Ainsi, par simple mesure de la conductance électrique totale aux bornes du circuit, il est possible de déduire la position des contacteurs et également de savoir si un contacteur est en position ouverte et lequel des contacteurs est dans cette position ouverte correspondant à un état de panne.

Le tableau suivant rend compte de l'unicité de la valeur de la conductance totale du circuit électrique pour les différentes combinaisons possibles des états des trois modules A, B et C.

| Etat du Module A | Etat du Module B | Etat du Module C | Conductance électrique totale (S) |
|---|---|---|---|
| 0 | 0 | 0 | 0 |
| 1 | 0 | 0 | 1 |
| 2 | 0 | 0 | 2 |
| 0 | 1 | 0 | 3 |
| 1 | 1 | 0 | 4 |
| 2 | 1 | 0 | 5 |
| 0 | 2 | 0 | 6 |
| 1 | 2 | 0 | 7 |
| 2 | 2 | 0 | 8 |
| 0 | 0 | 1 | 9 |
| 1 | 0 | 1 | 10 |
| 2 | 0 | 1 | 11 |
| 0 | 1 | 1 | 12 |
| 1 | 1 | 1 | 13 |
| 2 | 1 | 1 | 14 |
| 0 | 2 | 1 | 15 |
| 1 | 2 | 1 | 16 |
| 2 | 2 | 1 | 17 |
| 0 | 0 | 2 | 18 |
| 1 | 0 | 2 | 19 |
| 2 | 0 | 2 | 20 |
| 0 | 1 | 2 | 21 |
| 1 | 1 | 2 | 22 |
| 2 | 1 | 2 | 23 |
| 0 | 2 | 2 | 24 |
| 1 | 2 | 2 | 25 |
| 2 | 2 | 2 | 26 |

Comme représenté en figure 2, tous les modules sont reliés en parallèle entre eux et en série à une résistance supplémentaire Rₛ et forment ainsi un circuit diviseur de tension 12, ce qui permet de réduire l'influence de la température sur la mesure de la tension.

Une tension d'alimentation Vᵢₙ est appliquée à l'ensemble du circuit. Le paramètre mesuré est non plus la conductance aux bornes des modules mais la tension Vₒᵤₜ aux bornes de ceux-ci. Toutefois, il est nécessaire d'établir une table de correspondance entre la tension lue Vₒᵤₜ et la conductance totale du circuit puisque les différentes valeurs de tension ne sont pas réparties régulièrement sur une plage de valeurs entières de tension comme pour les valeurs de conductances.

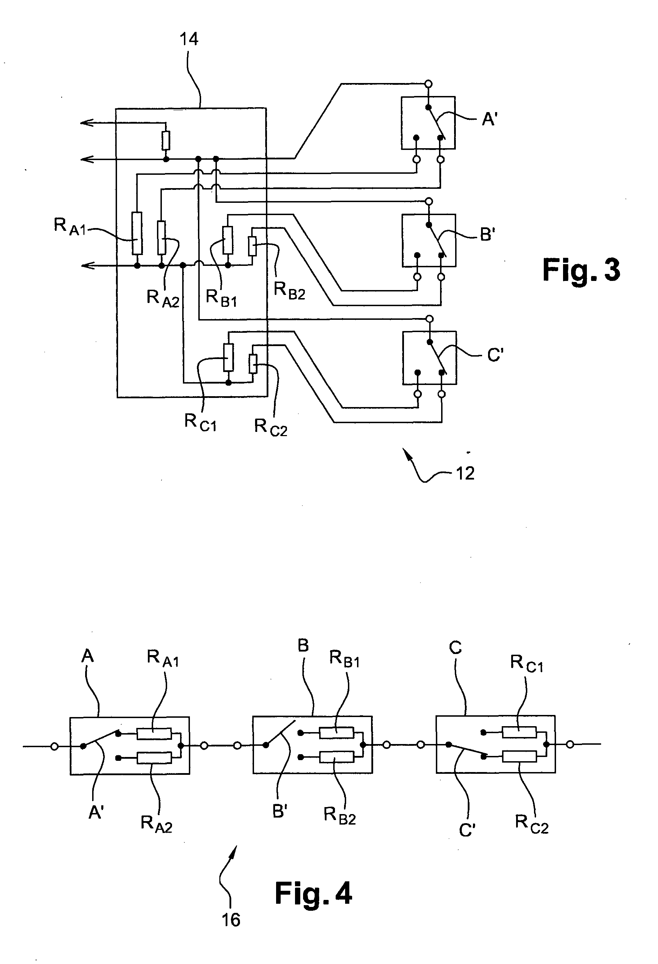

La réalisation précédente est particulièrement intéressante lorsqu'elle est utilisée dans un dispositif d'inverseur de poussée tel qu'en comprennent les avions modernes. Dans ce cas, on utilise des contacteurs à deux positions de contact (k=2). Les résistances sont montées dans un boîtier 14 éloigné des contacteurs A, B, C, ce qui permet de soumettre toutes les résistances à la même température et ainsi de limiter les effets de la température sur la mesure de la tension (figure 3).

Un tel dispositif d'inversion de poussée peut comprendre plusieurs portes chacune associée à une pluralité de contacteurs à deux positions. Dans une configuration particulière, chaque porte est associée à au moins trois contacteurs dont deux sont utilisés pour la détermination du niveau de fermeture de la porte et un troisième est utilisé pour la détermination du niveau d'ouverture de la porte. Chacun des deux premiers contacteurs comprend deux positions permettant d'obtenir l'information « porte complètement fermée » ou l'information « porte non complètement fermée ». Le troisième contacteur comprend deux positions de contact permettant d'obtenir l'information « porte complètement ouverte » ou « porte non complètement ouverte ».

Ainsi, la combinaison de ces informations permet de déterminer de manière certaine l'état ouvert ou fermé d'une porte donnée d'un dispositif d'inversion de poussée.

Le dispositif selon l'invention peut être intégré dans toutes les turbomachines actuelles à inverseurs de poussée, à grilles ou à volets par exemple, puisqu'il utilise les conducteurs de la technique antérieure entre le boîtier et les inverseurs de poussée et seul le nombre de conducteurs entre le boîtier et le calculateur est réduit.

La figure 4 représente un circuit 16 selon l'invention dans lequel les modules ont été agencés en série. Le fonctionnement de ce type de circuit est identique à celui d'un montage avec les modules en parallèle et le raisonnement tenu en référence à la figure 1 est valable lorsqu'il s'agit de résistances ohmiques puisqu'en série, ce sont les résistances qui s'additionnent. Toutefois, on comprend bien que dans le cas d'un montage en série des modules, dès qu'un contacteur est défaillant (son état étant égal à 0), alors l'impédance du circuit est infinie et il n'est pas possible de déterminer lequel des contacteurs est défaillant ni si plusieurs contacteurs sont défaillants.

L'invention décrite en référence aux dessins peut être aisément généralisée à N modules comprenant chacun un contacteur apte à établir k positions de contact distinctes. Notons que le nombre de positions de contact k dans chaque module peut être différent d'un module à l'autre. Par exemple, il est possible qu'un module comprenne un contacteur à k1 positions de contact distinctes ainsi que k1 résistances dont les états sont compris entre 1 et k1 et qu'un autre module comprenne un contacteur à k2 positions de contact distinctes ainsi que k2 résistances dont les états sont compris entre 1 et k2, avec k2>k1. Dans ce cas, la valeur de chaque conductance électrique (ou résistance ohmique, respectivement) de chacun des modules est déterminée en utilisant une progression géométrique de raison supérieure ou égale à k2+1, afin de garantir l'unicité de la conductance électrique totale (ou de la résistance ohmique totale, respectivement) du circuit.

## Revendications

1. Circuit (10, 16) de détection des positions individuelles d'une pluralité de contacteurs électriques **caractérisé en ce qu'**il comprend :
- une pluralité de modules (A, B, C) reliés en parallèle ou en série et comportant chacun un contacteur (A', B', C') à k positions distinctes de contact chacune reliée en série à une résistance (R_{A1}, R_{A2}, R_{B1}, R_{B2}, R_{C1}, R_{C2}) associée à une valeur entière d'état comprise entre 1 et k, les valeurs d'état dans un même module étant distinctes deux à deux ;
- chaque module (A, B, C) étant associé à un coefficient de pondération et ces coefficients de pondération suivant une progression géométrique de raison supérieure ou égale à k+1 ; et en - ce que
- la valeur de la conductance électrique (ou de la résistance ohmique, respectivement) de chaque résistance est égale à sa valeur d'état multipliée par le coefficient de pondération de son module (A, B, C).

2. Circuit selon la revendication 1, **caractérisé en ce que** les modules (A, B, C) sont reliés en parallèle et l'ensemble des modules est relié en série à une résistance supplémentaire (R_{S}) pour former un pont diviseur de tension (12).

3. Dispositif de détection des positions individuelles des portes d'un inverseur de poussée d'un turboréacteur, **caractérisé en ce qu'**il comprend un circuit (10, 16) selon la revendication 1 ou 2, dans lequel la position d'un contacteur est associée à la position d'une porte d'un inverseur de poussée.

4. Dispositif selon la revendication 3, **caractérisé en ce que** k est égal à 2, chaque position de contact d'un contacteur (A', B', C') étant choisie pour donner une information sur le niveau d'ouverture ou de fermeture d'une porte de l'inverseur de poussée.

5. Dispositif selon la revendication 4, **caractérisé en ce qu'**il comprend au moins trois contacteurs par porte dont deux contacteurs sont utilisés pour la détermination du niveau de fermeture de la porte et un autre contacteur est utilisé pour la détermination du niveau d'ouverture de la porte.

6. Dispositif selon l'une des revendications 3 à 5, **caractérisé en ce que** les résistances (R_{A1}, R_{A2}, R_{B1}, R_{B2}, R_{C1}, R_{C2}) des modules (A, B, C) sont montées dans un boîtier (14) éloigné des contacteurs (A', B', C') des inverseurs de poussée et relié à un calculateur.

7. Turbomachine, telle qu'un turboréacteur ou un turbopropulseur d'avion, **caractérisée en ce qu'**elle comprend un circuit de détection (10) selon la revendication 1 ou 2 ou un dispositif selon l'une des revendications 3 à 6.

## Patentansprüche

1. Schaltung (10, 16) zum Erfassen der einzelnen Stellungen einer Mehrzahl von elektrischen Kontaktgebern, **dadurch gekennzeichnet, dass** sie enthält:
- eine Mehrzahl von Modulen (A, B, C), die parallel oder in Reihe geschaltet sind und jeweils einen Kontaktgeber (A', B', C') mit k unterschiedlichen Kontaktstellungen aufweisen, die jeweils in Reihe mit einem Widerstand (R_{A1}, R_{A2}, R_{B1}, R_{B2}, R_{C1}, R_{C2}) geschaltet sind, dem ein ganzzahliger Zustandswert zwischen 1 und k zugeordnet ist, wobei die Zustandswerte in einem gleichen Modul sich paarweise unterscheiden;
- wobei jedem Modul (A, B, C) ein Gewichtungskoeffizient zugeordnet ist und diese Gewichtungskoeffizienten einer geometrischen Progression mit dem Wert größer oder gleich k+1 folgen; und dass
- der Wert der elektrischen Leitfähigkeit (bzw. des ohmschen Widerstands) eines jeden Widerstands gleich seinem Zustandswert multipliziert mit dem Gewichtungskoeffizienten seines Moduls (A, B, C) ist.

2. Schaltung nach Anspruch 1, **dadurch gekennzeichnet, dass** die Module (A, B, C) parallel geschaltet sind und die Gesamtheit der Module in Reihe mit einem zusätzlichen Widerstand (R_{S}) geschaltet ist, um eine Spannungsteilerbrücke (12) zu bilden.

3. Vorrichtung zum Erfassen der einzelnen Stellungen der Klappen einer Schubumkehreinrichtung eines Turbostrahltriebwerks, **dadurch gekennzeichnet, dass** sie eine Schaltung (10, 16) nach Anspruch 1 oder 2 umfasst, wobei die Stellung eines Kontaktgebers der Stellung einer Klappe einer Schubumkehreinrichtung zugeordnet ist.

4. Vorrichtung nach Anspruch 3, **dadurch gekennzeichnet, dass** k gleich 2 ist, wobei jede Kontaktstellung eines Kontaktgebers (A', B', C') dazu ausgewählt ist, eine Information über den Öffnungs- bzw. Schließgrad einer Klappe der Schubumkehreinrichtung zu geben.

5. Vorrichtung nach Anspruch 4, **dadurch gekennzeichnet, dass** sie pro Klappe zumindest drei Kontaktgeber enthält, von denen zwei Kontaktgeber zum Ermitteln des Schließgrads der Klappe verwendet werden und ein weiterer Kontaktgeber zum Ermitteln des Öffnungsgrads der Klappe verwendet wird.

6. Vorrichtung nach einem der Ansprüche 3 bis 5, **dadurch gekennzeichnet, dass** die Widerstände (R_{A1}, R_{A2}, R_{B1}, P_{B2}, R_{C1}, R_{C2}) der Module (A, B, C) in einem Gehäuse (14) montiert sind, das von den Kontaktgebern (A', B', C') der Schubumkehreinrichtung entfernt liegt und mit einem Rechner verbunden ist.

7. Turbomaschine bzw. Turbinentriebwerk, wie etwa Turbostrahltriebwerk oder Turbopropellertriebwerk von Flugzeugen, **dadurch gekennzeichnet, dass** sie bzw. es eine Erfassungsschaltung (10) nach Anspruch 1 oder 2 bzw. eine Vorrichtung nach einem der Ansprüche 3 bis 6 enthält.

## Claims

1. Circuit (10) for detecting individual positions of a plurality of electrical contactors, **characterized in that** it includes:
- a plurality of modules (A, B, C) connected in parallel or in series and each comprising a contactor (A', B', C') with k distinct contact positions each connected in series to a resistor (R_{A1}, R_{A2}, R_{B2}, R_{B2}, R_{C1}, R_{C2}) associated with a whole state value of between 1 and k, in which the state values in the same module are in distinct pairs;
- each module (A, B, C) is associated with a weighting coefficient and these weighting coefficients follow a geometric progression of reason greater than or equal to k+1; and **in that**
- the electrical conductance (or, respectively, ohmic resistance) value of each resistor is equal to its state value multiplied by the weighting coefficient of its module (A, B, C).

2. Circuit according to claim 1, **characterized in that** the modules (A, B, C) are connected in parallel and the assembly of modules is connected in series to a supplementary resistor (Rₛ) to form a voltage divider bridge (12).

3. Device for detecting the individual positions of the thrust reverser doors of a turbojet, **characterized in that** it includes a circuit (10) according to claim 1 or 2, in which the position of a contactor is associated with the position of a thrust reverser door.

4. Device according to claim 3, **characterized in that** k is equal to 2, with each contact position of a contactor (A', B', C') being chosen so as to provide information on the degree of opening or closing of a thrust reverser door.

5. Device according to claim 4, **characterized in that** it includes at least three contactors per door, of which two contactors are used for determining the degree of closing of the door and another contactor is used to determine the degree of opening of the door.

6. Device according to one of claims 3 to 5, **characterized in that** the resistors (R_{A1}, R_{A2}, R_{B2}, R_{B2}, R_{C1}, R_{C2}) of the modules (A, B, C) are mounted in a housing (14) separate from the contactors (A', B', C') of the thrust reversers and connected to a computer.

7. Turbine engine, such as a turbojet or a turbopropeller of an airplane, **characterized in that** it includes a detection circuit (10) according to claim 1 or 2 or a device according to one of claims 3 to 6.
